Europäisches Patentamt

European Patent Office

Office européen des brevets

(11) Numéro de publication: **0 221 810**
**A1**

## (12) DEMANDE DE BREVET EUROPEEN

(21) Numéro de dépôt: **86402293.4**

(22) Date de dépôt: **15.10.86**

(51) Int. Cl.⁴: **H 01 F 7/20**
**H 01 F 41/04, G 01 N 24/06**

(30) Priorité: **18.10.85 FR 8515510**

(43) Date de publication de la demande:
**13.05.87 Bulletin 87/20**

(84) Etats contractants désignés: **DE GB NL**

(71) Demandeur: **THOMSON-CGR**
**13, square Max-Hymans**
**F-75015 Paris (FR)**

(72) Inventeur: **Aubert, Guy**
**THOMSON-CSF SCPI 19, avenue de Messine**
**F-75008 Paris (FR)**

(74) Mandataire: **Grynwald, Albert et al**
**THOMSON-CSF SCPI 19, avenue de Messine**
**F-75008 Paris (FR)**

(54) **Procédé de réalisation d'une bobine de gradient, et bobine obtenue par ce procédé.**

(57) Pour réaliser une bobine de gradient, on décide de découper les conducteurs de cette bobine dans une plaque. On peut ainsi utiliser des conducteurs plats. Ceci est favorable à la réduction de la self inductance de la bobine à construire. La bobine est par ailleurs optimisée. On calcule les coefficients de la décomposition en harmoniques sphériques du champ qu'elle crée. On modifie sa structure de manière à annuler des coefficients de cette décomposition qui sont générateurs d'une inhomogénéité du champ. On montre que de cette manière la solution est optimum.

FIG_2

EP 0 221 810 A1

**Description**

PROCEDE DE REALISATION D'UNE BOBINE DE GRADIENT ET BOBINE OBTENUE PAR CE PROCEDE

La présente invention, due à la collaboration du Service National des Champs Intenses (Directeur M. AUBERT), a pour objet un procédé de réalisation d'une bobine de gradient ainsi qu'une bobine de gradient obtenue par ce procédé. Cette bobine de gradient est destinée à créer un gradient de champ magnétique dans un volume d'intérêt d'un appareil d'imagerie par résonance magnétique nucléaire. L'invention trouve plus particulièrement son application dans le domaine médical où l'imagerie par résonance magnétique nucléaire est unanimement reconnue comme aide au diagnostic. Elle peut bien entendu être mise en oeuvre dans d'autres domaines. Le but de la présente invention est de concourir à la création d'images d'un corps à examiner, plus fidèles ainsi que plus précises dans leur résolution.

Un appareil d'imagerie par résonance magnétique nucléaire comporte essentiellement trois types de bobines. Un premier type de bobines (qui peut éventuellement être remplacé par un aimant permanent) a pour objet de créer un champ magnétique homogène intense $B_0$ dans un espace prédéterminé d'intérêt. Un deuxième type de bobines, dites radiofréquence, a pour but de soumettre un corps examiné et placé sous l'influence du champ des premières bobines à des séquences d'excitation radiofréquence, et de mesurer un signal radiofréquence réémis en retour par des particules du corps. La réponse radiofréquence est une réponse en volume : toutes les particules d'une région du corps soumises à l'examen émettent en même temps leurs réponses radiofréquence. Pour créer une image, il est nécessaire de différencier ces réponses. A cette fin, les appareils d'imagerie comportent un troisième type de bobines, dites de gradient, pour superposer au champ intense des composantes d'un champ magnétique supplémentaire. La valeur de ces composantes est fonction des coordonnées dans l'espace de leur lieu d'application (classiquement, il est proposé d'organiser cette différenciation selon trois axes orthogonaux X, Y, Z ; par convention, l'axe Z est même généralement pris colinéaire au champ intense créé par le premier type de bobines). Autrement dit, chaque lieu de l'espace peut être codé par une valeur de champ différente : on exploite dans le signal réémis les modifications qui en résultent pour créer l'image.

Les bobines de gradient sont généralement réparties en trois familles : celle qui crée un gradient selon X, celle qui crée un gradient selon Y, et celle qui crée un gradient selon Z. Par exemple un gradient de champ selon X est un champ magnétique dont la distribution de la composante colinéaire au champ intense (Z), dans l'espace, est fonction uniquement de la coordonnée $x_i$ de son lieu d'application. Dans la pratique, elle y est même de préférence proportionnelle. Ceci signifie que toutes les particules d'un corps à examiner situées dans un plan parallèle à Y-Z et d'abscisse donnée $x_i$ sont soumises à un même champ total $B_0 + G_x.x_i$. Le gradient $G_x$ est la pente de la variation de la composante selon Z du champ supplémentaire apporté par ces bobines de gradient X.

L'acquisition d'une image nécessite donc au cours de l'application des séquences d'excitation radiofréquence. l'application conjointe de séquences de gradient de champ. Les séquences de gradient de champ dépendent du procédé d'imagerie mis en oeuvre. Ce procédé peut par exemple être du type 2DFT élaboré par MM. A. KUMAR et R.R. ERNST ou par exemple du type rétroprojection élaboré par M. P.C. LAUTERBUR. Quelle que soit la méthode d'imagerie retenue, une caractéristique des gradients de champ est qu'ils sont pulsés. Ils sont établis, ils persistent pendant une durée courte, puis ils sont coupés. Ceci peut advenir une ou plusieurs fois pendant chaque séquence. Cette particularité a pour conséquence que le fonctionnement des bobines qui les produisent doit être étudié non seulement en régime permanent, pendant l'application des gradients, mais encore pendant les transitoires résultant de leur établissement et leur coupure. Une autre caractéristique importante des gradients de champ concerne leur homogénéïté. Par homogénéïté on entend le respect, avec une tolérance donnée, et par un gradient de champ réel, d'une distribution théorique idéale que l'on voudrait imposer. En effet, les inhomogénéïtés de champ ont pour conséquence de fausser la différenciation que l'on cherche à imposer dans l'espace et qui est la base même de l'imagerie. De ce point de vue, les problèmes d'homogénéïté doivent être aussi bien résolus pour les gradients qu'ils peuvent l'être pour les champs homogènes intenses. La solution des problèmes posés par les transitoires se résoud en principe en réalisant des bobines les plus petites possibles. Plus elles sont petites, plus leur self inductance est petite, et moins la puissance à fournir pour produire le gradient de champ est importante. Par contre, pour l'homogénéïté, plus les bobines sont grandes et plus la distribution des champs qu'elles produisent peut être considérée comme homogène. Ces deux tendances sont donc contradictoires. En général, les bobines de gradient sont placées à l'extérieur et le plus près possible des bobines radiofréquence. Celles-ci déterminent en leur intérieur le volume d'examen où est placé le corps. Le problème à résoudre est alors, pour un emplacement imposé. de trouver des bobines de gradient qui produisent un gradient suffisamment fort ($G_x$). homogène, et dont la self inductance soit faible.

Il est connu dans l'état de la technique des formes particulières de bobines de gradient. Par exemple, pour un gradient ou $G_x$. ou $G_y$, ces bobines comportent des conducteurs formés autour d'un cylindre selon des contours dits en selle de cheval. Les bobines de l'invention sont en particulier de ce type mais présentent des particularités propres à résoudre au mieux le triple problème de la force, de l'homogénéïté, et de la puissance électrique à mettre en oeuvre. Pour de nombreuses raisons théoriques et technologiques, il est quelquefois fait usage dans les bobines de conducteurs méplats. Un conducteur méplat est un conducteur de section rectangulaire dont le rapport des côtés est approximativement 2. Cet usage découle de ce que les calculs de bobines sont entrepris avec des conducteurs théoriques de section nulle. Et dans la réalisation on approche cette forme théorique par une forme cylindrique, voire méplate. Par ailleurs les conducteurs méplats sont impropres à un façonnage dans un plan contenant le grand côté de leur section. Le façonnage devient même très difficile si le rapport des dimensions des côtés est plus grand que 2.

L'invention a pour objet de remédier aux inconvénients cités en réalisant une bobine dont les conducteurs sont découpés dans une plaque en matériau conducteur. L'épaisseur de la plaque, obtenue en laminant le matériau conducteur (essentiellement du cuivre), présente alors une constance suffisante pour que la section des conducteurs ne dépende que de la largeur de leur découpe. On réalise ainsi simplement des conducteurs plats : c'est-à-dire dont le rapport du petit côté de la section au grand côté de la section est élevé, approximativement supérieur à 5. Il en résulte une diminution de l'effet de peau du conducteur à la commutation : le conducteur plat présentant beaucoup de surface de peau. La puissance électrique nécessaire pour la mise en place du champ s'en trouve réduite. Autrement dit, le fonctionnement transitoire de la bobine de gradient se trouve ainsi amélioré. Par ailleurs, dans l'invention, le nombre des découpes et l'importance des chutes ont pu être diminués en choisissant de réaliser des bobines avec des conducteurs adjacents. Pour un nombre suffisant de conducteurs, il n'y a qu'un nombre égal (plus une unité) de découpes et de conducteurs. On n'est donc pas obligé de découper dans la plaque tous les conducteurs sur leurs deux côtés.

L'invention concerne un procédé de réalisation d'une bobine de gradient pour créer un gradient de champ magnétique dans un volume d'intérêt d'un appareil d'imagerie par résonance magnétique nucléaire, caractérisé en ce que :
- on optimise les dimensions, l'architecture, et le nombre des spires de la bobine en choisissant des conducteurs plats,
- on taille la bobine ainsi déterminée en pratiquant des découpes dans des feuilles de matériau conducteur dont l'épaisseur correspond à une caractéristique des conducteurs de la bobine,
- et en ce qu'on met en forme, autour d'un mandrin cylindrique, la bobine ainsi taillée.

L'invention concerne également une bobine de gradient pour créer un gradient de champ magnétique dans un volume d'intérêt d'un appareil d'imagerie par résonance magnétique nucléaire caractérisée en ce qu'elle comporte des spires dont le nombre, l'architecture et les dimensions sont optimisés pour pouvoir produire un gradient le plus intense et le plus homogène possible dans le volume d'intérêt tout en présentant, en mode pulsé, une résistance la plus faible possible à l'établissement du courant.

La présente invention sera mieux comprise à la lecture de la description qui suit et à l'examen des figures qui l'accompagnent. Elles ne sont données qu'à titre indicatif et nullement limitatif de l'invention. Sur les figures les mêmes repères désignent les mêmes éléments. Elles montrent :
- figure 1 : un schéma d'un appareil d'imagerie par résonance magnétique muni de bobines de gradient ;
- figure 2 : une vue schématique développée d'un exemple de réalisation d'une bobine d'une première famille de bobines de gradient selon l'invention ;
- figure 3 : une vue schématique développée de bobines de gradient de deux familles et leurs particularités de connexion ;
- figure 4 : une vue en coupe des trois familles de bobines de gradient dans une réalisation conforme à l'invention et montées sur un mandrin cylindrique circulaire ;
- figure 5 : un exemple de bobine de gradient selon l'invention pour la troisième famille.

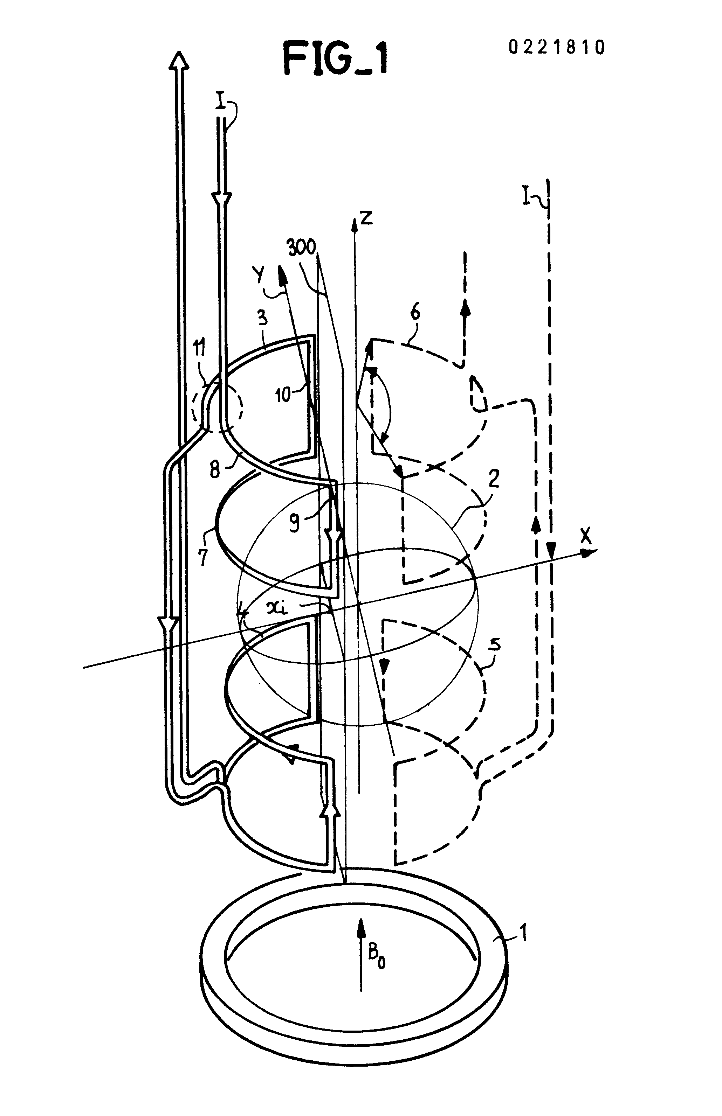

La figure 1 représente un appareil d'imagerie par résonance magnétique nucléaire. Il comporte des moyens symbolisés par une bobine 1 pour produire un champ magnétique homogène intense $B_0$ orienté dans une direction Z. Dans un volume d'intérêt 2 soumis à l'influence du champ $B_0$ on place, au moins en partie, un corps à examiner (non représenté). Ce corps est soumis à des séquences d'excitation radiofréquence par des bobines radiofréquence (non représentées). Ces bobines radiofréquence servent également à recevoir le signal réémis en retour par des particules du corps. Ce signal est traité par des moyens (non représentés) de traitement de signal qui en extraient des images représentatives de l'allure du corps, par exemple selon des coupes 300 d'abscisse $x_i$. Les plans de coupe tels que 300 peuvent être orientés d'une manière quelconque. Leur orientation est révélatrice des gradients de champ qui ont été superposés au champ $B_0$ pendant les séquences d'imagerie. Deux axes X,Y perpendiculaires entre eux et à l'axe Z permettent d'organiser l'espace. Une bobine de gradient, numérotée 3 à 6, d'une première famille est susceptible de produire un champ magnétique supplémentaire dont la composante orientée suivant Z varie en fonction de l'abscisse $x_i$. La bobine représentée est donc une bobine de gradient X. Elle comporte classiquement quatre jeux 3 à 6 sensiblement identiques et symétriques de conducteurs formés en selle de cheval. Par exemple le jeu 3 comporte un conducteur qui comprend deux brins en arceau respectivement 7 et 8 reliés entre eux par deux brins droits respectivement 9 et 10 colinéaires aux génératrices d'un mandrin cylindrique circulaire (non représenté) qui le porte. Par raison de symétrie, les quatre jeux de conducteurs sont parcourus par un même courant I. Pour des raisons de simplicité, il est même prévu d'alimenter en série plusieurs jeux : par exemple les jeux 3 et 4, et les jeux 5 et 6. Les sens de circulation du courant dans les conducteurs sont choisis pour produire le gradient de champ recherché.

On peut montrer que seule la composante selon Z du champ supplémentaire créé a une influence, tant que ces champs supplémentaires restent faibles par rapport au champ intense $B_0$ (par exemple de l'ordre du centième). Les composantes perpendiculaires à $B_0$ sont sans effet. En conséquence les champs produits par

3

les brins droits 9 et 10, parallèles à $B_0$, sont automatiquement perpen diculaires à $B_0$ : ils sont sans effet. Par ailleurs l'arceau conducteur 7 étant plus proche du volume d'intérêt que l'arceau conducteur 8, le champ qu'il y produit est plus fort. Aussi, des dispositifs de connexion des jeux tels que 11, sont d'une manière préférée agencés sur des arceaux conducteurs en retrait : là où leur présence produit le moins de perturbation. Une bobine d'une deuxième famille, produisant un gradient de champ selon Y a la même allure que celle produisant un gradient selon X. Elle est simplement tournée de 90° autour de l'axe Z. Pour des raisons d'encombrement, son diamètre intérieur est plus grand : elle enveloppe en partie la bobine X. Elle n'est pas représentée pour ne pas surcharger le dessin. La bobine de la troisième famille de bobines de gradient, selon l'axe Z, comporte des jeux de conducteurs symétriques par rapport au plan X-Y. Ces conducteurs ont tous une forme de virole, ils sont parcourus par un courant de même intensité mais de sens opposé de part et d'autre du plan X-Y.

Dans l'invention on réalise les bobines des trois familles par des découpes pratiquées dans des plaques en matériau conducteur. D'une manière préférée ces plaques sont en cuivre et leur épaisseur est de l'ordre ou inférieure à 1 % du rayon intérieur du cylindre qui ultérieurement porte les bobines. On a découvert que plus les conducteurs étaient plats plus l'influence de l'effet de peau intrinsèque était faible. D'une manière préférée, on choisit des conducteurs plats dont la largeur $\underline{d}$ est au moins 5 fois leur épaisseur $\underline{e}$. Dans un exemple préféré, elle vaut même 8,5 fois cette épaisseur. Connaissant l'intensité du gradient de champ et le volume d'intérêt dans lequel on veut l'imposer, on peut facilement approcher la valeur du courant inducteur nécessaire pour l'obtenir.Il suffit d'appliquer les lois de l'électromagnétisme. Connaissant la résistivité du matériau employé (le cuivre) on peut alors calculer la section de conducteur à présenter : c'est-à-dire l'épaisseur $\underline{e}$ et la somme des largeurs des brins des conducteurs dans chaque jeu.

La figure $\overline{2}$ montre une réalisation préférée d'une bobine de la première ou de la deuxième famille (gradients X ou Y). Dans la représentation, cette bobine est développée à plat. Chaque jeu noté 3 à 6 comporte deux groupes notés 12 et 13 de conducteurs en forme de spire. Chaque groupe comporte un certain nombre de spires. Dans un exemple, le groupe 12 en comporte cinq, le groupe 13 en comporte deux. Dans l'invention, le groupe 12 est imbriqué dans le groupe 13, et les spires des groupes 12 et 13 y sont même imbriquées les unes dans les autres. Ainsi elles peuvent toutes être taillées dans une même plaque. Ceci assure en même temps leur interconnexion électrique. D'une manière préférée, les spires sont adjacentes, et les groupes sont adjacents. De cette manière il suffit de réaliser une seule découpe dans la plaque le long de chaque conducteur pour le différencier d'un voisin.

L'imbrication est ici en forme de spirale carrée. Au raccordement, deux brins de spire, par exemple 14 et 15, se raccordant à des spires de niveaux inférieurs et supérieurs dans la spirale, contribuent à la réalisation d'un même arceau. Pour éviter qu'ils soient placés à des coordonnées $z_i$ différentes, il est prévu un espace 16 de glissement. Chaque extrémité de conducteur qui aboutit dans cet espace 16 y est légèrement déviée de manière à se poursuivre dans un arceau situé à un degré inférieur ou supérieur de la spirale. On peut montrer que ces raccordements étant tous parallèles les uns aux autres, et également adjacents, leur influence globale est négligeable. Par précaution l'espace de glissement est pratiqué sur les arceaux en retrait.

Un brin conducteur 17 d'amenée de courant est raccordé à un brin conducteur correspondant 18, au centre de la spirale 4. Le conducteur 18 est dans le prolongement du conducteur 17 (pour ne pas créer de composante parasite de courant, perpendiculaire à l'axe Z, qui créerait automatiquement une inhomogénéïté de la composante $B_z$ du champ supplémentaire). Les conducteurs 17 et 18 peuvent passer exactement au-dessus de la médiane des jeux auxquels ils appartiennent. Sous cette condition, les quatre jeux 3 à 6 sont exactement identiques les uns aux autres. Après être passé à travers le jeu 4, le courant emprunte comme voie de retour des con ducteurs 19 et 20 parallèles aux conducteurs 17 et 18. Après avoir parcouru la spirale 3 il sort à côté du brin d'amenée 17. L'entrée et la sortie sont raccordées, d'une manière classique, à des moyens d'alimentation.

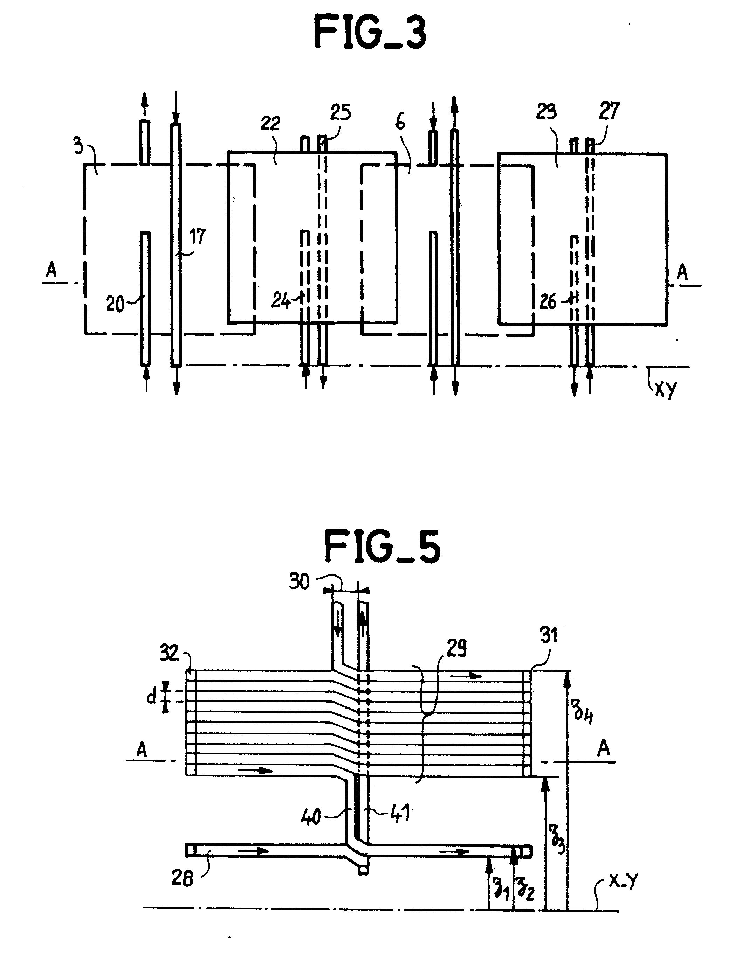

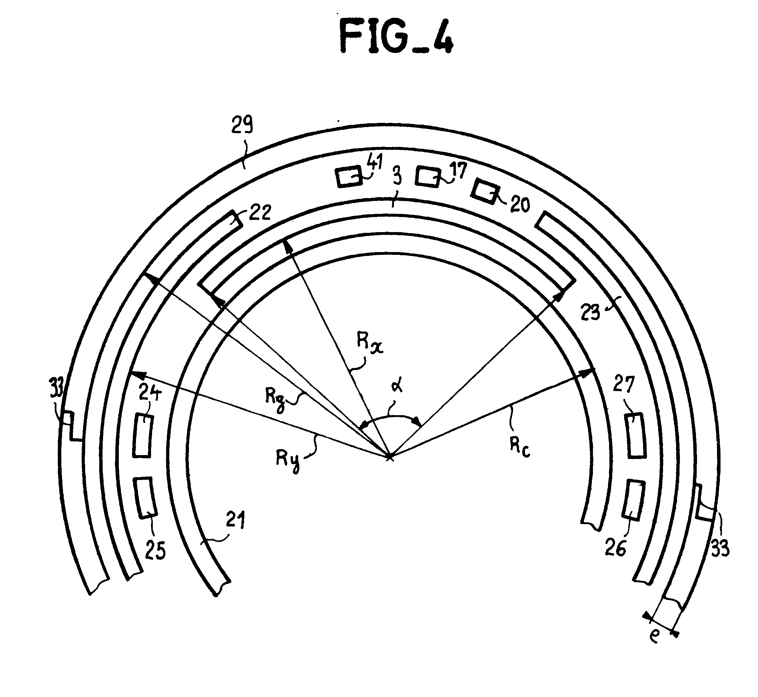

Comme les spires sont taillées dans des plaques, les conducteurs 17 à 20 empruntent pour le raccordement un plan supérieur ou inférieur à celui où sont placés les jeux 3 à 6. Les figures 3, vue en développé, et 4, vue en coupe selon un plan AA, perpendiculaire à l'axe Z et situé sensiblement au droit du groupement 12, rendent compte de la manière dont sont organisées les bobines de gradients X et Y. Les jeux 3 et 6 sont plaqués contre un mandrin circulaire 21 par exemple en résine époxyde armée de fibres de verre. Le mandrin 21 sert de support ; la bobine X y est collée au moyen d'une colle comprenant des fibres de verre imprégnées de matière polymérisable. Les bobines radiofréquence sont accrochées en son intérieur (elles ne sont pas représentées). Au-dessus du milieu du jeu 3, et par exemple collés au moyen d'une colle identique, sont placés les conducteurs 17 et 20. La couronne sur laquelle sont situés ces conducteurs 17 et 20 est occupée de part et d'autre par des jeux, respectivement 22 et 23, d'une bobine en charge de produire le gradient de champ Y. Les conducteurs 24-25 et 26-27 d'alimentation de ces derniers jeux sont diamètralement opposés les uns aux autres et laissent passer un courant symétrique. Ces conducteurs 24 à 27 occupent la partie de couronne laissée libre par les jeux 3 et 6 de la bobine X. Ils sont sousjacents aux jeux 22 et 23. En deux niveaux on place donc les jeux et les conducteurs d'alimentation des bobines des deux premières familles. On distingue sur la figure 4 les rayons. $R_c$ de l'extérieur du mandrin, $R_x$ de l'intérieur de la bobine de gradient X, et $R_y$ de l'intérieur de la bobine de gradient Y. Ces rayons se déduisent les uns des autres en tenant compte de l'épaisseur des plaques conductrices d'une part et des épaisseurs de colle utilisées d'autre part.

La figure 4 montre encore un rayon intérieur $R_z$ des jeux de conducteurs de la bobine de gradient Z vue en développée en partie sur la figure 5. La bobine de gradient Z comporte deux jeux de conducteurs symétriques par rapport au plan X-Y. Ici un seul jeu est représenté. Dans une réalisation préférée chaque jeu comporte deux groupements de conducteurs. Dans un exemple un premier groupement 28 comporte un conducteur et un deuxième groupement 29 en comporte dix. Les dix conducteurs du groupement 29 sont adjacents les uns aux autres : il faut onze découpes pour différencier les dix conducteurs du groupement 29. Les conducteurs de la bobine Z sont en forme de virole. De manière à être alimentés en série, ils sont raccordés successivement les uns aux autres. Au raccordement entre eux, ces conducteurs comportent également un espace de glissement 30. Dans l'espace de glissement 30, la fin d'une virole est raccordée au début d'une virole suivante. Dans leur installation autour du mandrin 21 les conducteurs de retour , comme le conducteur 41 (figures 4 et 5) sont situés dans la couronne de la bobine Y (et des conducteurs de retour 20 et 17 de la bobine X). Les trois bobines tiennent en trois niveaux.

On pourrait tailler toutes les viroles d'un jeu dans une plaque et, après formage, abouter électriquement les extrémités 31 et 32 de chacune des viroles. Le formage est ici entrepris, comme pour les bobines X et Y, après découpe, dans des rouleuses. Ces rouleuses comportent schématiquement deux rouleaux en vis à vis animés de vitesses différentes. Les plaques, une fois découpées, sont glissées entre ces rouleaux et se courbent selon un rayon de courbure qui dépend de la différence des vitesses. Pour faciliter le formage, on préfère cependant réaliser les viroles en deux parties : celle représentée sur la figure 5 et une autre partie non représentée comportant tout simplement onze segments droits d'égale longueur. Chaque partie est formée selon une demi-circonférence égale et chaque arceau d'une partie est abouté à un arceau conducteur correspondant de l'autre partie. Pour faciliter la connexion électrique des extrémités 31 et 32, les arceaux peuvent éventuellement comporter un embrèvement comme montré en 33 sur la figure 4.

Les découpes dans les plaques sont réalisées d'une manière préférée avant le formage. Comme elles sont rectilignes, elles peuvent être faites de diverses manières : avec une fraise, une scie, ou même un laser. D'une manière préférée elles sont effectuées avec une grignoteuse. Pour faciliter le formage et éviter que les conducteurs se tordent d'une manière non désirée, on laisse de loin en loin dans les découpes des ponts que l'on fait sauter ultérieurement.

Ayant ainsi imposé des contraintes plus liées à des impératifs de fabrication qu'à des impératifs d'homogénéïté, de self inductance minimale, ou de gradient de champ le plus élevé pour les bobines considérées, on s'attache ensuite, dans l'invention, à calculer les dimensions des éléments de ces bobines qui permettent d'y satisfaire. La méthode de calcul utilisée est originale. Elle consiste à utiliser un développement en harmoniques sphériques de la composante réduite, selon Z, du champ supplémentaire imposé par une bobine quelconque en un endroit donné de coordonnées sphériques : $r$, $\theta$, $\varphi$. Cette décomposition s'écrit de la manière suivante :

$$\frac{B_z(r,\theta,\varphi)}{B_s} = H_0 + \sum_{n=1}^{n\,\infty} \left(\frac{r}{r_0}\right)^n \left[\sum_{m=1}^{m=n} I_n^m \cos m\varphi \sqrt{\frac{(n-m)!}{(n+m)!}}\; P_n^m(\cos\theta)\right]$$

$$+ \sum_{n=1}^{n\,\infty} \left(\frac{r}{r_0}\right)^n \left[\sum_{m=1}^{m=n} J_n^m \sin m\varphi \sqrt{\frac{(n-m)!}{(n+m)!}}\; P_n^m(\cos\theta)\right]$$

$$+ \sum_{n=1}^{n\,\infty} \left(\frac{r}{r_0}\right)^n \left[H_n P_n(\cos\theta)\right]$$

$$(1)$$

Dans cette formule $B_z$ est la composante selon Z du champ supplémentaire total créé par la bobine. $B_s$ est un champ de référence permettant de définir des coefficients $H_n$, $I_n^m$ et $J_n^m$ sans dimension. Le rayon réduit $r/r_0$ mesure le module de la distance $r$ d'un point quelconque de la sphère d'intérêt 2 au rayon $r_0$ de cette sphère. Les fonctions $P_n(\cos\theta)$ et $P_n^m(\cos\theta)$ sont les polynômes de Legendre respectivement d'ordre $n$ et de valeurs propres $n$ et $m$. Les coefficients $H_n$, $I_n^m$ et $J_n^m$ dépendent de la structure géométrique de la bobine. Selon les symétries et antisymétries des structures, certains coefficients disparaissent de l'expression ci-dessus. Ainsi pour le gradient X elle devient :

$$\frac{B_z(r,\theta,\varphi)}{B_s} = (\frac{r}{r_o})\ I_1^1\ \cos\varphi\sqrt{\frac{1}{2!}}\ P_1^1(\cos\theta)$$

$$+ (\frac{r}{r_o})^3\ I_3^1\ \cos\varphi\sqrt{\frac{2!}{4!}}\ P_3^1(\cos\theta)$$

$$+ (\frac{r}{r_o})^3\ I_3^3\ \cos3\varphi\sqrt{\frac{1!}{6!}}\ P_3^3(\cos\theta)$$

$$+ (\frac{r}{r_o})^5\ I_5^1\ \cos\varphi\sqrt{\frac{4!}{6!}}\ P_5^1(\cos\theta)$$

$$+ N\ I_5^3\ + M\ I_5^5\ + \ \cdot\ \cdot\ \cdot \tag{2}$$

Dans cette formule ne restent des $I_n^m$ que ceux pour lesquels $\underline{n}$ et $\underline{m}$ sont impairs, $\underline{m}$ étant inférieur ou égal à $\underline{n}$. Tous les $J_n^m$ et les $H_n$ y sont nuls. Pour le gradient Y, I est remplacé par J et l'expression à sensiblement la même allure. Pour le gradient Z il ne reste que les termes en $H_n$. L'expression devient :

$$\frac{B_z(r,\theta,\varphi)}{B_s} = (\frac{r}{r_o})\ H_1\ P_1(\cos\theta) + (\frac{r}{r_o})^3 H_3\ P_3(\cos\theta) + (\frac{r}{r_o})^5\ H_5 P_5(\cos\theta) + \ ... \tag{3}$$

On dispose pour calculer les différents coefficients H, I ou J des paramètres de structure concernant les bobines. Pour les bobines de gradients X et Y, il s'agit des altitudes $z_i$ et $z_j$ du bord des arceaux de chacune des spires et également des ouvertures angulaires $\alpha$ de chacune des spires. Pour le gradient Z il s'agit uniquement des altitudes $z_i$ des bords de chacune des viroles. L'épaisseur $\underline{e}$ n'intervient pas si elle est suffisamment petite pour correspondre au cas de conducteurs théoriques d'épaisseur idéale nulle. Des contraintes supplémentaires de non chevauchement des spires et d'encombrement sont imposées par le choix des techniques de fabrication de l'invention. Elles ont seulement pour effet de limiter le nombre des solutions envisageables.

La méthode de détermination et d'optimisation de l'architecture des conducteurs de l'invention est décrite maintenant. Elle consiste, après avoir choisi la largeur $\underline{d}$ des conducteurs, à rendre les gradients les plus homogènes possibles tout en produisant le gradient le plus fort possible pour un courant donné. Par exemple, on dit que le gradient Z est homogène à l'ordre 5 quand les termes $H_3$ et $H_5$ de la formule (3) sont nuls. Dans ce cas particulier d'homogénéité à l'ordre 5, on montre que chaque jeu de la bobine de gradient Z situé de part et d'autre du plan médian X-Y doit être constitué de deux groupements de viroles comportant des nombres respectifs $n_1$ et $n_2$ de viroles. On a découvert que pour $n_1$ donné, le résultat n'était atteint que pour des valeurs de $n_2$ supérieures à une certaine valeur minimum, nettement plus grande que $n_1$. Par exemple, pour d = 0,069 $R_z$ et $n_1$ = 1, le résultat ne peut être atteint que pour $n_2 \geqq 8$, si $n_1$ = 2 il faut $n_2 \geqq 18$, etc...

Les contraintes d'alimentation liées aux transitoires lors de l'établissement ou de la coupure des gradients imposent de réduire la self inductance de la structure. On peut montrer que cette self inductance croît avec $n_1$ et $n_2$. Connaissant les temps de montée des gradients (dictés par la séquence d'imagerie choisie) et les caractéristiques des générateurs dont on dispose, on peut calculer une self inductance limite (à ne pas dépasser) pour la bobine de gradient Z. Ceci détermine le couple $n_1$-$n_2$ qui donne le plus grand $H_1$ tout en restant en dessous du seuil imposé par la self limite à ne pas dépasser. Dans une réalisation préférée, on a retenu $n_1$ = 1 et $n_2$ = 10. Si l'on appelle $z_1$, $z_2$, $z_3$ et $z_4$ les altitudes des bords de chacun des deux groupements de conducteurs de la bobine de gradient Z (figure 5), et si on retient une contrainte d'adjacence des viroles à tailler dans une plaque on choisit $z_1$ = 0,356347.$R_z$, $z_3$ = 0,893059.$R_z$, et d = 0,069.$R_z$. Les coordonnées $z_2$ et $z_4$ se déduisent simplement.

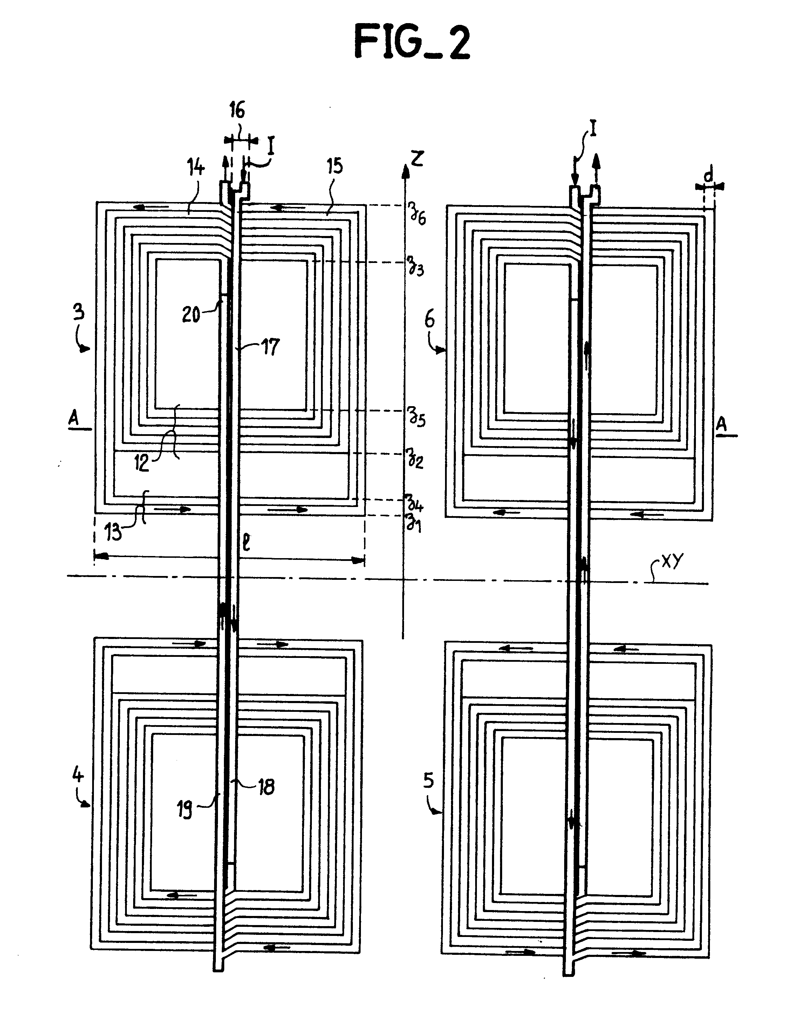

Pour les bobines de gradients X ou Y, la démarche est la même. Par exemple pour le gradient X, il faut obtenir un $I_1^1$ maximum tout en annulant $I_3^1$ et $I_3^3$ pour avoir un gradient homogène à l'ordre 3. Ceci est possible pour une bobine dont chacun des quatre jeux comprend un seul groupement de spires. Avec deux groupements de conducteurs dans chaque jeu, comme représenté à la figure 2, on peut accroître l'homogénéité en annulant en plus $I_5^1$ et en imposant des contraintes supplémentaires liées à la technologie de fabrication. En particulier on peut imposer que les conducteurs aient tous une même largeur et qu'ils ne se chevauchent pas.

Comme pour le gradient Z on recherche, après avoir choisi une largeur $\underline{d}$, et pour chaque couple $n_1$-$n_2$ de nombre de spires dans chaque groupement, les dimensions pour lesquelles $I_3^1$, $I_3^3$ et $I_5^1$ sont nuls tout en rendant $I_1^1$ maximum. Puis compte tenu des impératifs de self limite à ne pas dépasser, on en déduit un couple limite et des dimensions optimum. Dans une solution préférée $n_1 = 2$, $n_2 = 5$, $d = 0,069\ R_x$ et les altitudes des projection $z_1, z_2, z_3$ du bord des arceaux (ceux des bords les plus près du plan médian X-Y orthogonal à Z au centre de la sphère 2) sont respectivement (figure 2) : $z_1 = 0,111393\ R_x$, $z_2 = 0.567901\ R_x$ et $z_3 = 2,383976\ R_x$. Dans ce cas, la largeur $I$ de chaque jeu vaut $2,305872\ R_x$. On en déduit les altitudes $z_4$, $z_5$ et $z_6$ connaissant $n_1$, $n_2$ et $\underline{d}$. Pour la bobine de gradient Y, on remplace $R_x$ par $R_y$.

La méthode de détermination des conducteurs de l'invention diffère des méthodes de l'état de la technique. Dans celui-ci on ne calcule pas les coefficients de la décomposition en harmoniques sphériques de la composante Z du champ. On calcule ces composantes selon Z elles-mêmes. Pour une structure théorique de bobines (en selle de cheval pour les gradients X ou Y) on en arrive à une carte type de distribution du champ dans des plans. La sagacité de l'homme de métier intervient alors pour pondérer l'effet d'une selle par l'effet d'une autre selle. Ainsi de suite, on ajoute des selles et on arrive à obtenir l'homogénéité requise. Ce faisant, on a aucune certitude d'avoir atteint un optimum d'homogénéité, de self minimale, et de gradient le plus fort. Et dans la pratique on ne l'obtient d'ailleurs pas. Toutes les manipulations de l'homme du métier le conduisent en définitive à accumuler des spires supplémentaires, de formes diverses. Ceci se fait toujours au détriment de la self de la bobine. Selon les idées qui habitent l'homme du métier et les priorités qu'il avance, il découvre des solutions différentes. La méthode de détermination proposée par l'invention, permet d'aboutir d'une manière sûre à l'optimum. En fonction de choix technologiques, R et $\underline{d}$, on est maintenant capable de proposer la structure qui présente le gradient maximum ($H_1$ ou $I_1^1$ ou $J_1^1$) en même temps que la self inductance minimale et l'homogénéité à l'ordre le plus élevé.

L'épaisseur $\underline{e}$ n'intervient que pour fixer la puissance moyenne dissipée dans le système au cours des diverses séquences d'imagerie. Son choix résulte d'un compromis entre cette puissance, inversement proportionnelle à $\underline{e}$ d'une part et d'autre part la masse de conducteur et les difficultés de fabrication (découpage, roulage, collage,...) qui augmentent avec $\underline{e}$. Dans l'exemple préféré : e = 3 mm.

## Revendications

1. Procédé de réalisation d'une bobine (3-6) de gradient pour créer un gradient de champ magnétique dans un volume (2) d'intérêt d'un appareil (1) d'imagerie par résonance magnétique nucléaire, caractérisé en ce que :
- on optimise (formule 1) les dimensions, l'architecture, et le nombre des spires de la bobine en choisissant des conducteurs plats,
- on taille (figures 2, 5) la bobine ainsi déterminée en pratiquant des découpes dans des feuilles de matériaux conducteurs dont l'épaisseur correspond à une caractéristique des conducteurs de la bobine,
- et en ce qu'on met en forme autour d'un mandrin (21) cylindrique la bobine ainsi taillée.

2. Procédé selon la revendication 1, caractérisé en ce que pour déterminer on choisit l'épaisseur (e) des feuilles en fonction du gradient à imposer dans le volume d'intérêt et du courant inducteur nécessaire pour l'obtenir.

3. Procédé selon la revendication 1 ou 2, caractérisé en ce que pour déterminer on choisit une largeur (d) de brin conducteur supérieure d'au moins cinq fois à leur épaisseur (e).

4. Procédé selon l'une quelconque des revendications 1 à 3, caractérisé en ce que pour optimiser on choisit l'épaisseur et la largeur des conducteurs plats dans des rapports valant, respectivement, sensiblement 1 % au plus et 7 % du rayon du mandrin cylindrique qui les porte.

5. Procédé selon l'une quelconque des revendications 1 à 4, caractérisé en ce que pour optimiser on choisit de réaliser la bobine (X,Y) en deux groupes (12, 13) imbriquées de spires imbriquées et en ce qu'on calcule les dimensions et le nombre de spires de chaque groupe pour homogénéiser les champs.

6. Procédé selon la revendication 5, caractérisé en ce que pour les imbrications on choisit de réaliser des groupes adjacents de spires adjacentes toutes dans un même plan.

7. Procédé selon l'une quelconque des revendications 1 à 4, caractérisé en ce que pour optimiser on choisit de réaliser la bobine (Z) en deux groupes (28, 29) de spires adjacentes et en ce qu'on calcule le nombre de spires de chaque groupe pour homogénéiser les champs.

8. Procédé selon l'une quelconque des revendications 5 à 7, caractérisé en ce que pour calculer :
- on choisit des couples ($n_1$, $n_2$) de nombres de conducteurs à arranger dans les groupes,
- on calcule les coefficients (H,I,J), correspondant à ces choix, de la décomposition en harmoniques sphériques du champ à créer,
- on retient les couples de nombre de conducteurs qui donnent, jusqu'à un ordre donné ($\underline{n}$), à ces

coefficients, des valeurs prédéterminées,
- et on décide du nombre de conducteurs de chaque groupe en prenant dans les couples retenus celui qui donne le gradient le plus fort avec une self inductance en dessous d'un seuil fixé qui correspond à un fonctionnement transitoire de la bobine ainsi construite.

9. Procédé selon l'une quelconque des revendications 1 à 8, caractérisé en ce qu'on choisit des feuilles de même épaisseur.

10. Procédé selon l'une quelconque des revendications 1 à 9, caractérisé en ce que pour découper on utilise un laser.

11. Procédé selon l'une quelconque des revendications 1 à 9, caractérisé en ce que pour découper on utilise une fraise.

12. Procédé selon l'une quelconque des revendications 1 à 9, caractérisé en ce que pour découper on utilise une grignoteuse.

13. Procédé selon l'une quelconque des revendications 1 à 12, caractérisé en ce que on laisse des ponts à la découpe.

14. Procédé selon l'une quelconque des revendications 1 à 12, caractérisé en ce que pour former on roule la bobine taillée.

15. Bobine de gradient pour créer un gradient de champ magnétique dans un volume d'intérêt d'un appareil d'imagerie par résonance magnétique nucléaire, caractérisée en ce qu'elle comporte des spires dont le nombre, l'architecture, et les dimensions sont optimisés pour pouvoir produire un gradient le plus intense et le plus homogène possible dans le volume d'intérêt, tout en présentant en mode pulsé une résistance la plus faible possible à l'établissement du courant.

16. Bobine selon la revendication 15, caractérisée en ce que les conducteurs utilisés dans la bobine sont plats, le rapport du petit côté, l'épaisseur ($e$), de la section au grand côté, la largeur ($d$), de cette section est supérieure ou égale à 5.

17. Bobine selon la revendication 15 ou la revendication 16, caractérisée en ce que les spires y sont distribuées dans des jeux symétriques qui comprennent chacun deux groupements (12, 13 et 28, 29) de spires formées de brins conducteurs.

18. Bobine selon la revendication 17, caractérisée en ce que les spires d'un groupement sont imbriquées les unes dans les autres (figure 2), les deux groupements étant imbriqués l'un dans l'autre.

19. Bobine selon la revendication 17 ou la revendication 18, caractérisée en ce que les conducteurs et/ou les groupements sont adjacents les uns aux autres.

20. Bobine selon l'une quelconque des revendications 17 ou 19, caractérisée en ce qu'elle est destinée à produire un gradient de champ orienté (Z) comme le champ intense de l'appareil d'imagerie et en ce qu'elle comporte un premier groupement avec une spire et un deuxième groupement avec dix spires adjacentes (figure 5).

21. Bobine selon la revendication 20, caractérisée en ce qu'elle est portée par un mandrin cylindrique de rayon $R_z$, les spires étant orthogonales à l'axe de ce mandrin, l'abscisse de la projection sur cet axe du début des groupements valant respectivement 0,356.$R_z$ et 0,893 $R_z$, la largeur $d$ des conducteurs valant 0.069 $R_z$.

22. Bobine selon la revendication 19, caractérisée en ce qu'elle est destinée à produire un gradient de champ orthogonal au champ intense de l'appareil d'imagerie et en ce qu'elle comporte un premier groupement avec deux spires et un deuxième groupement avec cinq spires.

23. Bobine selon la revendication 22, caractérisée en ce qu'elle est portée par un mandrin cylindrique de rayon $R_x$, les spires étant formées en selle de cheval sur la surface de ce mandrin et comportant des brins conducteurs en arceau dont la projection sur l'axe est comprise respectivement entre 0,111 $R_x$ et 0,249 $R_x$, entre 0,568 $R_x$ et 0,913 $R_x$ et entre 2,384 $R_x$ et 2,867 $R_x$, la largeur $d$ des conducteurs valant 0,069 $R_x$.

24. Bobine selon l'une quelconque des revendications 14 à 23, caractérisée en ce qu'elle comporte des spires alimentées en série et raccordées entre elles dans un espace (16 ou 30) de glissement où toutes les extrémités à raccorder passent du niveau d'une spire au niveau d'une autre spire.

FIG_1

0221810

FIG_2

0221810

## FIG_3

## FIG_5

# FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | FR-A-2 549 281 (C.G.R. MEV) * Page 4, lignes 5-8; page 5, lignes 9-28 * | 1,3 | H 01 F 7/20 H 01 F 41/04 G 01 N 24/06 |
| | --- | | |
| A | DE-A-1 946 059 (THE PERKIN-ELMA CO.) * Figures * | 5-7 | |
| | --- | | |
| A | FR-A-2 411 478 (EURATOM) | | |
| | --- | | |
| A | FR-A-2 290 748 (CENTRE TECHNIQUE DES INDUSTRIES MECANIQUES) | | |
| | --- | | **DOMAINES TECHNIQUES RECHERCHES (Int. Cl.4)** |
| A | FR-A-2 473 215 (CEM COMPAGNIE ELECTRO-MECANIQUE) | | |
| | --- | | H 01 F 5/00 |
| A | EP-A-0 096 516 (M.M.M. CO.) | | H 01 F 7/00 G 01 N 24/00 |
| | ----- | | |

Le présent rapport de recherche a été établi pour toutes les revendications

| Lieu de la recherche | Date d'achèvement de la recherche | Examinateur |
|---|---|---|
| LA HAYE | 28-10-1987 | VANHULLE R. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82